Europäisches Patentamt

European Patent Office

Office européen des brevets

(11) Publication number: **0 114 943**
**B1**

# EUROPEAN PATENT SPECIFICATION

(45) Date of publication of patent specification: **10.08.88**

(51) Int. Cl.⁴: **C 23 C 18/18,** C 25 D 5/44, H 05 K 3/06

(21) Application number: **83110672.9**

(22) Date of filing: **26.10.83**

(54) Process of plating on anodized aluminium substrates.

(30) Priority: **27.12.82 US 453022**

(43) Date of publication of application:
**08.08.84 Bulletin 84/32**

(45) Publication of the grant of the patent:
**10.08.88 Bulletin 88/32**

(84) Designated Contracting States:
**DE FR GB**

(56) References cited:
**US-A-3 340 161**
**US-A-3 340 164**

**CHEMICAL ABSTRACTS, vol. 87, 1977, page 227, no. 42952p, Columbus, Ohio, US C. YOSHIMURA et al.: "Electroless planting of anodized aluminum"**

**PLATING, vol. 60, no. 6, June 1973, page 637 P.BALAKRISHNA et al.: "Electroless copper on alumina and other substrates"**

(73) Proprietor: **International Business Machines Corporation**
**Old Orchard Road**
**Armonk, N.Y. 10504 (US)**

(72) Inventor: **Burns, Richard Wayne**
**805 Garden Path**
**Round Rock Texas 78664 (US)**
Inventor: **Mahmoud, Issa Said**
**10500 Settlers Trail**
**Austin Texas 78750 (US)**

(74) Representative: **Colas, Alain**
**Compagnie IBM France Département de Propriété Intellectuelle**
**F-06610 La Gaude (FR)**

Courier Press, Leamington Spa, England.

## Description

### Technical field

This invention relates to a process for plating copper on hard anodized aluminium substrates.

### Background art

Prior art shows that plating of aluminium and its alloys reveals that porous anodizing has been extensively investigated as a surface pre-treatment. For example, U.S. Patent 3,943,039 teaches an anodizing step before plating with nickel. Wernick and Pinner, in *Surface Treatment of Aluminium*, discuss plating methods in which anodizing is used as a pre-treatment step. In the October 1982 issue of the American Electroplaters Society Journal, *Plating and Surface Finishing*, David E. Thomas, page 57, discusses the use of anodizing as pre-treatment to plating, in an article entitled "Adhesion Failure of Electrodeposited Coatings on Anodized Aluminium Alloys".

All of the above-referenced art relates only to thin anodic coatings. Such thin usually use phosphoric acid anodizing. The resulting coating is not a good insulator, and with sufficient current density, electrodeposition is possible.

US—A—3 340 161 also describes a well known method for the manufacturing of printed circuits and particularly to a method for producing a printed circuit pattern on an anodized aluminium substrate. The method involves the initial formation on the anodized layer of a thin silica film followed by the application of a silicone coating thereon, the latter being baked to cure the coating and simultaneously seal the pores of the anodized layer. The coated and sealed layer is then sensitized and activated and the steps of rinsing in distilled water, plating in an electroless nickel bath, then plating in an acidic copper bath complete the processing. However, in this method, the HCl concentration is too low to perform an adequate etching of the surface of the anodized coating and therefore to allow the direct plating of thick coatings.

More recently, anodized aluminium has been investigated as a dielectric material for use in electronic packaging. Metalization of thick anodic coatings is known to be achieved by lamination of copper foils followed by etching. Such a process limits utilization of anodized substrates to one sided-circuit board applications.

Many processes are known for plating aluminium and aluminium alloys in the raw oxidized and anodized states. Anodized aluminium plating has been limited to relatively thin coatings of up to 0,051 millimeters thickness. These coatings are porous and with proper plating conditions, certain metals may be plated onto the coating without surface conditioning.

Thick coatings, over 0,1 milimeters are non-conductive and direct plating to these coatings has been heretofore unattainable.

An object of the invention is to provide a method as defined in claim 1.

### Disclosure of invention

The present invention provides a significantly lower cost packaging alternative with good heat dissipation properties resulting from an improved process for plating thick anodic coatings on aluminium substrates. It also provides a novel pre-treatment formulation which is significantly faster. An aluminium work piece is anodized to form a thick anodic coating. The work piece is then sensitized and etched at room temperature for two minutes in a solution comprised of stannous chloride, hydrochloric acid and water. Following a distilled water rinse, the work piece is activated in a solution containing palladium chloride and hydrochloric acid. The activation step is followed by another rinse in distilled water. The result is a substrate which is plated first with an electroless nickel bath then followed by electroless nickel bath then followed by electrolytic plating in a conventional acid copper bath.

The invention is defined in the appended claims.

Plating over thick anodic coatings, whether electroless or electrolytic solutions are used, is possible after our sensitizing and activating steps.

### Best mode for carrying out the invention

The following example illustrates the practice of this invention and includes the following steps:

(a) Hard anodize;

(b) seal;

(c) sensitize and etch in a solution consisting of:
   stannous chloride ($SnCl_2 \cdot 4H2O$) 40 g/l
   hydrochloric acid (HCL, 36%) 60 ml/l
   water 1 liter;

(d) rinse in distilled water;

(e) activate in the solution of .25 grams palladium chloride, ($PdCl_2 \cdot$ ) hydrochloric acid, HCl., 36%, 2.5 ml;

(f) rinse in distilled water;

(g) plate in an electroless nickel bath for 5—10 minutes;

(h) plate in acidic copper bath at 1—2 amp/dm$^2$ current density; voltage 1—2 volt; temperature of 21°—27°C

It is to be noted that the plating time for copper is a function of the desired coating thickness. The following mathematical relationship relates time and thickness.

$$\text{time (hours)} = \frac{144 \times t \times 16{,}4 \times \text{Sp. Gr.} \times 100}{1000 \times \text{g/amp-hour} \times \text{C.D.} \times \text{C.Eff.}}$$

where

t=thickness in mil;
Sp.Gr.=Specific Gravity—8,95 for copper;
g/amp—hour=1,182 for copper;
C.D.=Current density (1—2 amp · dm$^2$);
C.Eff.=Current efficiency=95% for acid copper bath.

The sealing step is accomplished by using the anodized aluminium work piece as anodes in an electrolytic cell. A current density of 100—200 mamp/dm$^2$ and a duration of 20 minutes minimum at room temperature is preferred.

This sealing step utilizes a method in which cracks in the anodic coating are filled with polymerized silica having a thermal coefficient of expansion substantially comparable of that of the coating.

## Claims

1. A method for plating thick anodic coatings on aluminium substrate comprising the steps of:
—anodizing the aluminium substrate
—sealing the said anodized substrate
—rinsing in distilled water
—sensitizing the said anodized substrate in a solution comprising a stannous salt, acid and water
—activating in a solution comprising a salt of palladium and acid
—rinsing in distilled water
—plating in an electroless nickel bath
—plating in an acidic copper bath
characterized in that:
—the said anodizing step provides a thick anodized coating,
—said sensitizing step occurs in a solution containing 40 grams per litre of stannous chloride and 60 millilitres per liter of 36% hydrochloric acid in 1 litre of water.
2. The method of Claim 1 wherein said activating step solution contains 0,25 grams Pd Cl$_2$ per 2,5 millilitres of 36% hydrochloric acid.
3. A substrate for printed circuit boards made in accordance with the method of Claims 1 or 2.

## Patentansprüche

1. Methode zum Aufbringen eines dicken anodischen Überzugs auf einem Aluminiumsubstrat, die folgende Schritte aufweist:
—Anodisieren des Aluminiumsubstrats
—Versiegeln des genannten anodisierten Aluminiumsubstrats
—Spülen mit destilliertem Wasser
—Sensibilisieren des genannten anodisierten Substrats in einer Lösung aus Zinn(II)-Salz, Säure und Wasser
—Aktivieren in einer Lösung aus Palladium-Salz und Säure
—Spülen mit destilliertem Wasser
—Plattieren in einem stromlosen Nickelbad
—Plattieren in einem acidischen Kupferbad,
dadurch gekennzeichnet, dass:
—der genannte Anodisierschritt einen dicken anodisierten Überzug bildet,
—der genannte Sensibilisierungsschritt in einer Lösung erfolgt, die 40 Gramm Zinn(II)-Chlorid pro Liter und 60 Milliliter 36%-iger Salzsäure pro Liter in einem Liter Wasser enthält.
2. Methode nach Anspruch 1, bei der der genannte Aktivierungsschritt in einer Lösung mit 0,25 Gramm Pd Cl$_2$ pro 2,5 Milliliter 36%-iger Salzsäure erfolgt.
3. Substrat für gedruckte Schaltungen, die nach der Methode der Ansprüche 1 oder 2 hergestellt sind.

## Revendications

1. Une méthode de placage de revêtements anodiques épais sur un substrat d'aluminium, comprenant les étapes suivantes:
—l'anodisation du substrat d'aluminium,
—la protection dudit substrat anodisé,

**0 114 943**

—le rinçage dans de l'eau distillée,

—la sensibilisation dudit substrat anodisé dans une solution comprenant un sel stanneux, de l'acide et de l'eau,

—l'activation dans une solution comprenant un sel de palladium et de l'acide,

—le rinçage dans de l'eau distillée,

—le placage dans un bain de nickel non-électrolytique,

—le placage dans un bain de cuivre acide, caractérisée en ce que:

—ladite étape d'anodisation assure la formation d'un épais revêtement anodisé,

—ladite étape de sensibilisation se déroule dans une solution contenant 40 grammes par litre de chlorure stanneux et 60 millilitres per litre de 36% d'acide chlorhydrique dans un litre d'eau.

2. La méthode de la revendication 1 dans laquelle ladite solution d'étape d'activation contient 0,25 grammes de Pd Cl$_2$ par 2,5 millilitres d'acide chlorhydrique à 36%.

3. Un substrat pour tableaux de circuits imprimés réalisé selon la méthode des revendications 1 ou 2.

4